# EUROPÄISCHE PATENTANMELDUNG

(11) **EP 2 287 884 A2**
(43) Veröffentlichungstag der Anmeldung: **23.02.2011**
(21) Anmeldenummer: 10007230.5
(22) Anmeldetag: 13.07.2010
(51) Int. Cl.: H01J 37/32, H01J 37/34

(54) **Gasflusssputterquelle**

(30) Priorität: 18.08.2009 DE 102009037853
(71) Anmelder: Fraunhofer-Gesellschaft zur Förderung der angewandten Forschung e.V., 80686 München (DE)
(72) Erfinder: Jung, Thomas, Dr., 38173 Sickte (DE)
(74) Vertreter: Pfenning, Meinig & Partner GbR

(57) **Zusammenfassung**

Die vorliegende Erfindung betrifft eine Gasflusssputterquelle, die eine Hohlkathode (2) mit einer Eintritts- und Austrittsöffnung für Inertgas aufweist, wobei im Bereich der Austrittsöffnung der Hohlkathode ein Gehäuse (7) mit einer Ausnehmung angeordnet ist.

## Beschreibung

Die vorliegende Erfindung betrifft eine Gasflusssputterquelle, die eine Hohlkathode mit einer Eintritts-und Austrittsöffnung für Inertgas aufweist, wobei im Bereich der Austrittsöffnung der Hohlkathode ein Gehäuse mit einer Ausnehmung angeordnet ist.

Das Gasflusssputtern ist ein Verfahren zur Herstellung dünner Schichten. Es beruht wie alle Sputterverfahren auf der Zerstäubung der Kathode (Target) einer Niederdruck-Glimmentladung durch die auftreffenden energiereichen Ionen aus dem Plasma der Glimmentladung. Das abgetragene Kathodenmaterial gelangt in Form einzelner Atome, Ionen oder Cluster aus Atomen zur zu beschichtenden Oberfläche (Bauteil, Substrat) und schlägt sich dort als Schicht nieder. Das Targetmaterial ist meist ein Metall, eine Legierung oder ein Halbleiter. Man erhält daher metallische oder halbleitende Schichten. Das Transportgas ist meist Argon. Wird dem (chemisch inerten) Arbeitsgas ein chemisch reaktives Gas beigemischt, beispielsweise Sauerstoff, Stickstoff oder gasförmige Kohlenwasserstoffe, so reagiert das Targetmaterial auf der Targetoberfläche, im Gasraum oder/und auf der Substratoberfläche mit diesem Gas und es bilden sich Oxid-, Nitrid- oder Karbidschichten (reaktives Sputtern).

Beim Gasflusssputtern wird zur Erzielung einer hohen Beschichtungsrate eine Hohlkathoden-Glimmentladung zur Erzeugung des Plasmas verwendet. Diese Entladung erzeugt eine deutlich höhere Plasmadichte als eine gewöhnliche Glimmentladung. Aufgrund des vergleichsweise hohen Arbeitsdruckes einer Hohlkathoden-Glimmentladung (meist mehr als 0.1 mbar) erfolgt der Materialtransport vom Target zum Substrat mittels eines gerichteten Gasstromes.

Gasflussputterquellen sind unter anderem beschrieben in den Patent Abstracts of Japan, Publication Number 63045367 A, sowie in DD 294 511 und DE 42 35 953.

Dementsprechend besteht eine Gasflusssputterquelle gewöhnlich aus folgenden Komponenten: einer Hohlkathode, gebildet durch ein oder mehrere Targets, mit mindestens je einer Einströmöffnung und Ausströmöffnung, einer Kühlvorrichtung für die Targets, einer Vorrichtung für die Gaszufuhr und einem Gehäuse. Das Gehäuse hat mehrere Funktionen. Es beschränkt die Glimmentladung auf die innere Oberfläche der Hohlkathode (Abschirm-Funktion), es dient der vollständigen Führung des Arbeitsgases durch die Hohlkathode hindurch und es behindert das Eindringen von Reaktivgasen oder Restgas in die Hohlkathode. Außerdem kann es für die Hohlkathoden-Glimmentladung die Funktion der Anode übernehmen.

Die Hohlkathode kann unterschiedliche geometrische Formen aufweisen. Häufig besteht sie aus zwei parallel angeordneten rechteckigen Platten (Linearquelle), häufig auch aus einem Tubus (Rundquelle). Weiterhin sind prismenförmige polygonale Quellen möglich sowie trichter- oder scheibenförmige Quellen.

Ein für den Langzeitbetrieb der Quellen wichtiger Bereich ist die Mündung. Sie wird gebildet durch die Ausströmöffnung der Hohlkathode und die sich anschließende Öffnung des Gehäuses.

Bekannt sind Mündungen, bei denen die Hohlkathode in Gestalt einer 90°-Kante endet und die Gehäuseöffnung aus geraden Schnittkanten des Gehäuse-Bleches besteht (DE 103 52 516). Die DE 04 235 953 beschreibt eine Gehäuseöffnung in Gestalt eines Kanals mit parallelen inneren Oberflächen. Durch diese Ausführung wird das Eindringen von Restgas oder Reaktivgas in die Hohlkathode erschwert.

Nachteilig an diesen Lösungen ist, dass sich insbesondere auf der Oberfläche der Gehäuseöffnung, aber auch auf der Targetoberfläche im Bereich der Ausströmöffnung, während des Betriebes der Quelle Beläge bilden, die die Funktion der Quelle und die Schichtqualität beeinträchtigen.

Insbesondere kommt es zur Partikelbildung durch Delamination der Beläge, zur ungleichmäßigen Beschichtung durch in den Gasstrom hineinwachsende Beläge oder zur Ratenverminderung im Ergebnis einer Querschnittsverringerung der Mündung. Schließlich können zwischen Gehäuse und Kathode elektrische Kurzschlüsse auftreten.

Daher ist es Aufgabe der vorliegenden Erfindung, eine Quellenmündung zu finden, die einen Langzeitbetrieb der Quellen ohne Beeinträchtigung der Schichtqualität, der Beschichtungsrate und der Prozessstabilität ermöglicht.

Diese Aufgabe wird durch die Merkmale der Gasflusssputterquelle gemäß Patentanspruch 1 gelöst. Die abhängigen Patentansprüche stellen dabei vorteilhafte Weiterbildungen der Gasflusssputterquelle dar.

Erfindungsgemäß wird somit eine Gasflusssputterquelle mit einer Hohlkathode bereitgestellt, die eine Eintritts- und Austrittsöffnung für Inertgas aufweist, wobei sich im Bereich der Austrittsöffnung an die Hohlkathode ein Gehäuse anschließt, das eine Ausnehmung aufweist, deren Weite mindestens 80 % der Weite der Ausströmöffnung beträgt, wobei zumindest die der Hohlkathode abgewandte Seite des Gehäuses eine gekrümmte Oberfläche aufweist.

Der besondere Effekt einer derart gestalteten Gehäuseöffnung bzw. -ausnehmung ist somit, dass sich einerseits quasi keine lokalen Beläge mit großer Dicke bilden können und andererseits die Haftfestigkeit der dennoch einmal gebildeten Beläge so groß ist, dass keine selbständige Delamination stattfindet.

Insbesondere erhält die Gehäuseöffnung eine Gestalt, die im Wesentlichen eine stetige Öffnung des freien Querschnittes in Richtung auf das Substrat aufweist sowie auf scharfe, hervorspringende Kanten im Bereich der Gasströmung verzichtet.

Darüber hinaus können Werkstoff und Oberflächenstruktur der Gehäuseöffnung so gewählt werden, dass eine sehr gute Haftfestigkeit gewährleistet ist. Dazu wird ein Material mit einer hohen Oberflächenenergie verwendet und dessen Oberfläche wird stark aufgeraut, beispielsweise durch Strahlen, Schleifen oder Ätzen, oder mit einer porösen Struktur belegt, beispielsweise mit einem (Metall-) Gewebe.

Schließlich kann die Gehäuseöffnung so ausgeführt werden, dass während der Beschichtung keine großen Temperaturänderungen erfolgen, beispielsweise durch gute Wärmeableitung, durch aktive Kühlung oder durch Regelung der Temperatur auf einen vorgegebenen Wert.

Der Krümmungsradius der sich im Bereich der Gasströmung befindlichen, d.h. an die Gasströmung unmittelbar angrenzenden Oberflächenbereiche des Gehäuses im Bereich der Gehäuseöffnung (Mündungsbereich) in Richtung der Gasströmung ist bevorzugt an allen Stellen größer als 3 % der Weite der Ausströmöffnung (der Hohlkathode), vorzugsweise größer als 10 %, besonders bevorzugt größer als 20 %.

In einer weiteren bevorzugten Ausführungsform beträgt der Krümmungsradius jedoch maximal das Dreifache der Weite der Ausströmöffnung.

Die Bezeichnung Krümmungsradius ist dabei als punktueller Begriff zu verstehen, der die jeweilige infinitesimale Krümmung der Oberfläche des Gehäuses angibt. Insofern ist die Krümmung trotz des Begriffes "Radius" nicht auf kreisförmige Krümmungen beschränkt.

In einer weiteren bevorzugten Ausführungsform ist vorgesehen, dass zumindest die Oberfläche der der Hohlkathode abgewandten Seite, in Projektionsrichtung auf die der Hohlkathode abgewandte Seite des Gehäuses, in einem ringförmigen oder zweifach streifenförmigen Bereich seitlich zur Ausnehmung hin gekrümmt ist, wobei der Bereich sich vom Rand der Ausströmöffnung auf eine Länge von mindestens 10 %, bevorzugt mindestens 50 % der Weite der Ausströmöffnung erstreckt.

Diese Ausführungsform sieht vor, dass zumindest die Oberfläche der der Hohlkathode abgewandten Seite des Gehäuses bereichsweise eine Krümmung der Oberfläche aufweist. Die Krümmung schließt sich dabei unmittelbar an die Ausnehmung an und verläuft dabei in seitlicher Richtung von der Ausnehmung weg. Die Krümmung ist dabei in Projektion auf die Oberseite des Gehäuses auf einen ringförmigen oder zweifach streifenförmigen Bereich beschränkt. Außerhalb dieses ringförmigen oder zweifach streifenförmigen Bereiches verläuft die Oberfläche des Gehäuses beispielsweise orthogonal zur Durchströmrichtung der Hohlkathode. Die Breite des ringförmigen oder zweifach streifenförmigen Bereiches bemisst sich dabei beginnend vom Rand der Ausströmöffnung auf einen Bereich von mindestens 10 % der Weite der Ausströmöffnung.

Erfindungsgemäß ist die Art der Krümmung dabei auf keine spezielle geometrische Form beschränkt, d.h. die Krümmung kann gleichmäßig, aber auch mit zunehmendem Abstand von der zentralen Ausnehmung abflachend verlaufen. Insbesondere kommen als mögliche geometrische Formen der Krümmung dabei kreisförmig, ellipsoid, hyperbolisch, zykloid, parabolisch oder sinusförmig verlaufende Krümmungen in Frage.

In einer weiteren alternativen Ausführungsform ist vorgesehen, dass sowohl die der Hohlkathode abgewandte Seite als auch die der Hohlkathode zugewandte Seite des Gehäuses eine gekrümmte Oberfläche aufweist. Auch bei dieser Ausführungsform kann wie bereits weiter oben angesprochen vorgesehen sein, dass sich die Krümmung der Unterseite auf einen ringförmigen oder zweifach streifenförmigen Bereich begrenzt, wobei bezüglich der Breite dieses Bereichs die oben genannten Angaben in analoger Weise zutreffen.

Weiter bevorzugt ist, dass die Weite der Ausnehmung des Gehäuses mindestens 80 %, bevorzugt mindestens 90 %, weiter bevorzugt mindestens 100 %, besonders bevorzugt 100 % bis 150 %, insbesondere 100 % bis 120 % der Weite der Ausströmöffnung beträgt. Bei einem Wert der Weite der Ausnehmung des Gehäuses von kleiner als 100 % ist dabei die Ausnehmung des Gehäuses kleiner bemessen als die Ausströmöffnung der Hohlkathode, während bei größeren Werten die Weite bzw. der Durchmesser der Ausnehmung des Gehäuses größere Werte aufweist.

Vorteilhaft ist weiterhin, wenn das Gehäuse in Strömungsrichtung des Inertgases beabstandet zur Hohlkathode angeordnet ist, bevorzugt in einem Abstand zwischen 0,5 und 10 mm, besonders bevorzugt zwischen 2 und 4 mm.

Weiter vorteilhaft ist, wenn das Gehäuse zumindest im Bereich der Ausnehmung aus einem Material mit einer Oberflächenenergie γ größer als 0,5 N/m, bevorzugt größer als 2 N/m ausgeführt ist, insbesondere aus Stahllegierungen und/oder Aluminium besteht. Unter dem Bereich der Ausnehmung ist dabei beispielsweise der ringförmige oder zweifach streifenförmige Bereich zu verstehen, in dem das Gehäuse an seiner Ober-und/oder Unterseite (im Sinne einer der der Hohlkathode abgewandten oder zugewandten Seite des Gehäuses) eine Krümmung aufweist. Insbesondere kommen für die Materialien dabei Stahllegierungen und/oder Aluminium in Frage.

Ebenso ist bevorzugt, dass das Gehäuse zumindest im Bereich der Ausnehmung aus einem Material mit einer Wärmeleitfähigkeit λ von mindestens 40 W/(m·K), bevorzugt 100 W/(m·K), besonders bevorzugt 250 W/(m·K) besteht.

Zur Vermeidung der Ablösung etwaiger Ablagerungen von den zu sputternden Materialien während des Betriebs der Gasflusssputterquelle ist es insbesondere von Vorteil, wenn die Oberfläche des Gehäuses zumindest im Bereich der Ausnehmung eine aufgeraute Oberfläche mit einem Rauwert Ra von mindestens 0,5 µm, bevorzugt mindestens 3 µm besitzt.

In einer weiter vorteilhaften Ausführungsform ist die Oberfläche des Gehäuses zumindest im Bereich der Ausnehmung mit einem Netz überzogen, das bevorzugt aus dem gleichen Material gebildet ist, wie das Gehäuse und/oder weist Vertiefungen, insbesondere Löcher, Rillen und/oder Furchen, auf. Durch diese Ausführungsform erhält die Oberfläche des Gehäuses eine makroskopische Strukturierung und wird dadurch zu einer unebenen Oberfläche. Auch dadurch kann ein Ablösen von Abscheidungen von Sputtermaterial während des Betriebs der Gasflusssputterquelle weitgehend vermieden werden. Vorzugsweise weisen dabei die Strukturen der Vertiefungen steile Flanken, d.h. Flanken mit einer Neigung von 45° gegenüber der Normalen der Oberfläche auf.

Weiter vorteilhaft ist, wenn das Gehäuse mindestens eine Ausnehmung zur Einleitung von Reaktivgas aufweist.

Ebenso ist es vorteilhaft, wenn das Gehäuse mindestens eine Kühl- und/oder Heizvorrichtung aufweist.

Ebenso ist es vorteilhaft, wenn die Austrittsöffnung der Hohlkathode eine konische Absenkung aufweist.

Die vorliegende Erfindung wird anhand der nachfolgenden Ausführungen in Verbindung mit den beigefügten Figuren näher erläutert, ohne diese auf die dort im einzelnen dargestellten speziellen Parameter zu beschränken.

Im Rahmen der folgenden Ausführungen gelten die folgenden Definitionen:

Die Weite der Ausströmöffnung ist der Abstand direkt gegenüberliegender Kathodenflächen im Bereich der Ausströmöffnung.

Den Mündungsbereich bilden alle Oberflächenbereiche des Gehäuses, deren Abstand zur geradlinigen Verlängerung der inneren Targetoberfläche in Richtung des Gasstromes kleiner ist als 10 % der Weite der Ausströmöffnung, bevorzugt kleiner als 50 %, besonders bevorzugt kleiner als 100 %.

Der Krümmungsradius der freiliegenden Oberfläche im Mündungsbereich in Richtung der Gasströmung ist an allen Stellen kleiner als das Dreifache der Weite der Ausströmöffnung, vorzugsweise kleiner als das Einfache.

Die Weite der Öffnung im Gehäuse beträgt an allen Stellen mindestens 80 % der Weite der Ausströmöffnung (der Hohlkathode) und höchstens 100 % zuzüglich der doppelten Targetdicke, bevorzugt 100 % bis 120 %.

In einer bevorzugten Ausführungsform der Gasflusssputterquelle gelten die genannten Eigenschaften des Krümmungsradius im Mündungsbereich auch für das Gebiet des Überganges von den der Gasströmung direkt zugewandten Oberflächenbereichen zu den dem jeweiligen Target zugewandten Oberflächenbereichen.

Ebenso ist es jedoch möglich, dass die genannten Eigenschaften des Krümmungsradius im Mündungsbereich für das Gebiet des Überganges von den der Gasströmung direkt zugewandten Oberflächenbereichen zu den dem Target zugewandten Oberflächenbereichen nicht gelten und somit die Weite der Öffnung im Gehäuse an allen Stellen mindestens 100 % der Weite der Ausströmöffnung der Hohlkathode beträgt.

Weitere Ausführungen der Gasflusssputterquelle sehen vor, dass der Mündungsbereich aus einem Material mit sehr hoher Oberflächenenergie besteht oder dass die Oberflächenstruktur eine große effektive Oberfläche besitzt und eine geometrische Verzahnung von Oberfläche und Belägen ermöglicht.

Möglich sind weiterhin Ausführungsformen der Mündung aus einem Material mit hohem Wärmeleitvermögen, mit großem Wärmeleitquerschnitt und/oder mit einer zusätzlichen Vorrichtung zur Kühlung oder zur Regelung der Temperatur.

Die Zuführung eines Reaktivgases durch einen Schlitz oder mehrere Einzellöcher im Mündungsbereich des Gehäuses ist ebenso möglich.

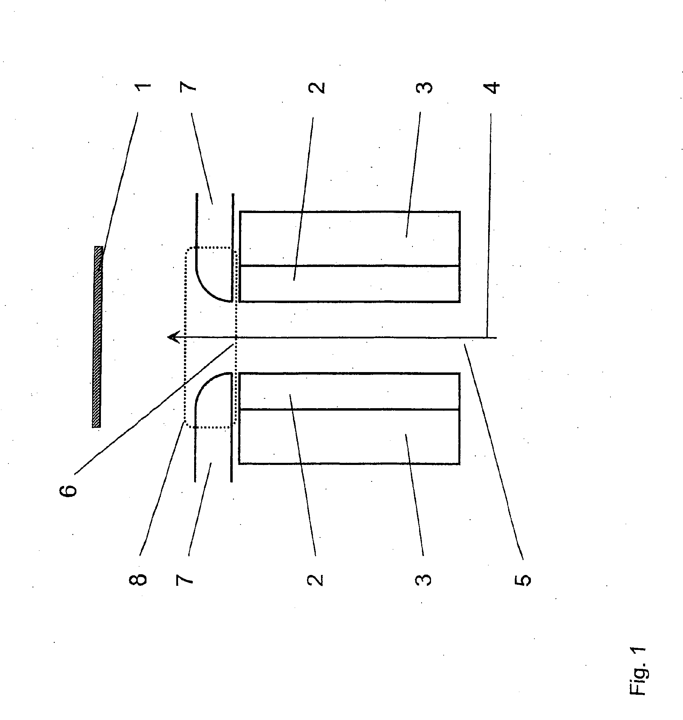

Fig. 1 zeigt die Hohlkathode 2 und den Mündungsbereich 8 des Gehäuses 7 einer Gasflusssputterquelle, wobei das Gehäuse 7 im Mündungsbereich 8 einen Krümmungsradius von 50 % der Weite der Ausströmöffnung 6 der Hohlkathode 2 aufweist, woran sich eine ungekrümmte Fläche anschließt. Sowohl die Ausströmöffnung 6 als auch die Ausnehmung des Gehäuses 7 weisen dabei in Projektion auf die Durchströmrichtung 4 kreisrunde Gestalt auf. Die Kathode 2 weist eine Einströmöffnung 5 auf und wird in Richtung 4 von Inertgas (Ar) in Richtung des Substrates 1 durchströmt. Die Hohlkathode 2 weist ebenso eine Kühlung 3 auf. Die Größe der Gehäuseöffnung beträgt 100 % der Ausströmöffnung 6 der Hohlkathode 2. Der Mündungsbereich des Gehäuses ist punktiert markiert. Die Ausführungsform gemäß Fig. 1 stellt somit den zentralen Querschnitt durch eine tubulare Gasflusssputterquelle dar. Das gleiche Bild ergibt sich für den Querschnitt einer linearen Gasflusssputterquelle.

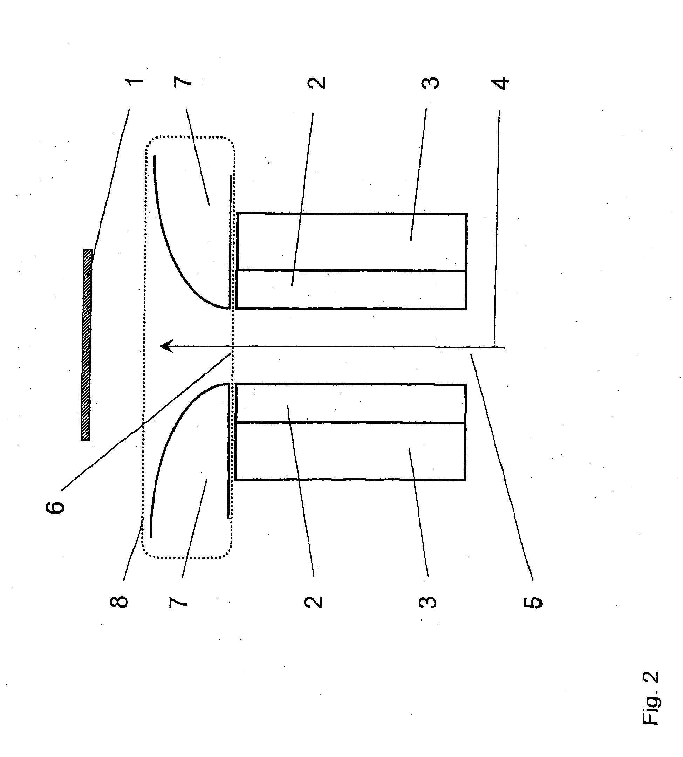

Fig. 2 zeigt eine Anordnung wie in Fig. 1, jedoch mit einem Krümmungsradius des Gehäuses 7, der von 50 % der Weite der Ausströmöffnung 6 im Bereich der Ausströmöffnung 6 gleichmäßig auf etwa 400 % zunimmt. Die Größe der Gehäuseöffnung beträgt auch hier 100 % der Ausströmöffnung 6 der Hohlkathode 2. Der große Querschnitt des Gehäuses 7 ermöglicht eine wirksame Wärmeabfuhr aus den dem Hohlkathodenplasma und der Gasströmung 4 zugewandten Bereichen.

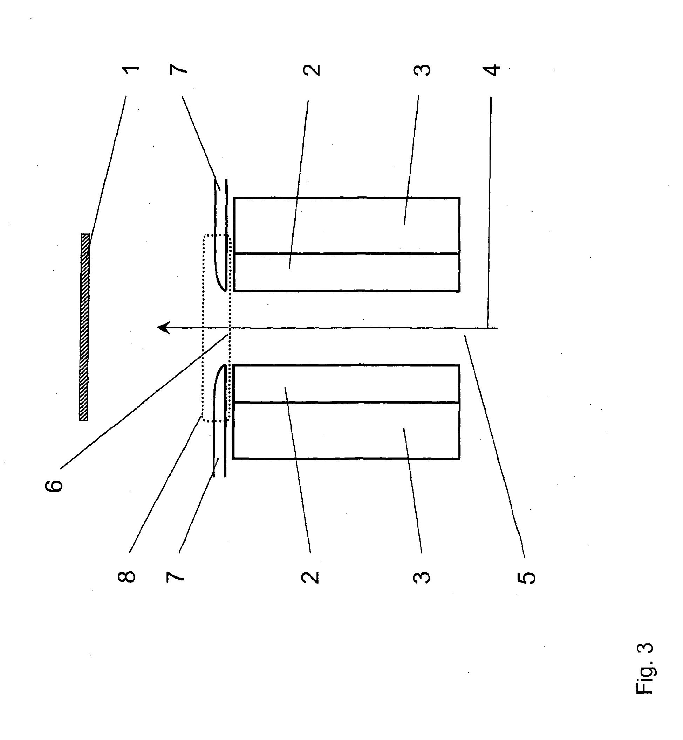

Fig. 3 zeigt eine Anordnung mit einem Krümmungsradius des Mündungsbereiches 8 von zunächst 10 % an der Ausströmöffnung, der gleichmäßig auf etwa 400 % wächst. Der Durchmesser der Gehäuseöffnung beträgt ebenfalls 100 % der Ausströmöffnung der Hohlkathode.

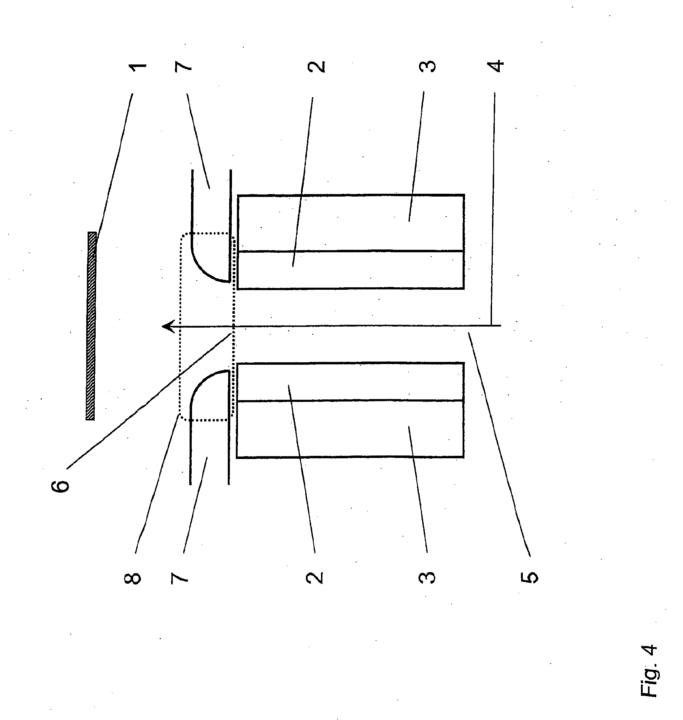

Fig. 4 zeigt der Querschnitt durch eine Gasflussputtequelle, bei der die Öffnung im Gehäuse 120 % der Weite der Ausströmöffnung 6 der Hohlkathode 2 beträgt. Der Krümmungsradius im Mündungsbereich 8 beträgt 50 % der Weite der Ausströmöffnung 6 der Hohlkathode 2. Vorteilhaft an dieser Ausführung sind der verminderte Strömungswiderstand für das Transportgas, was zu einer höheren Beschichtungsrate führt, und der größere Abstand der Quellenmündung zum Transportgasstrom, was zu langsamerem Wachstum der Beläge führt.

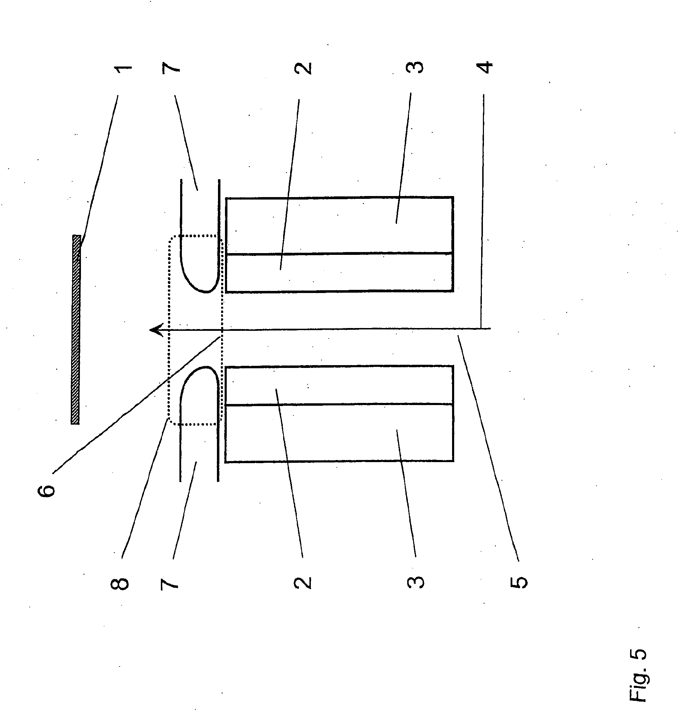

In Fig. 5 ist die Öffnung des Gehäuses 7 so ausgeführt, dass auch im Gebiet des Überganges von den der Gasströmung 4 direkt zugewandten Oberflächenbereichen zu den dem jeweiligen Target 2 zugewandten Oberflächenbereichen der Krümmungsradius deutlich vergrößert ist. Er liegt hier im Bereich von etwa 10 % bis 20 % der Weite der Ausströmöffnung 6. Im übrigen Bereich liegt der Krümmungsradius bei 20 %, wächst auf 50 % und schließlich auf einen unendlich großen Wert (ebene Fläche). Ein besonderer Vorteil dieser Ausführung besteht darin, dass auf den unmittelbar benachbarten Oberflächenbereichen des Gehäuses 7 und/oder der Targets 2 besonders dicke Beläge aufwachsen können, ehe die Hohlkathodenglimmentladung infolge von Kurzschlüssen unterbrochen wird.

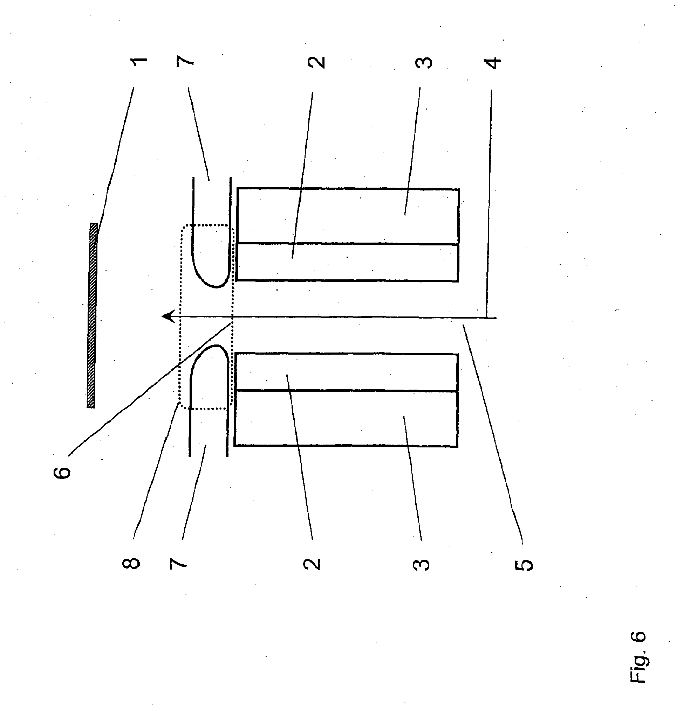

Die Gehäuseöffnung nach Fig. 6 ist vergleichbar mit der nach Fig. 5, jedoch beträgt ihre Weite nur 80 % der Weite der Ausströmöffnung 6. Daraus ergibt sich der Vorteil, dass sich im Außenraum der Hohlkathode 2 befindendes Restgas oder Reaktivgas nur in sehr geringem Maße in die Hohlkathode 2 eindringen kann. Dadurch werden ein besonders stabiler Betrieb der Hohlkathodenglimmentladung und ein gleichmäßig hoher Sputterabtrag von den Targets 2 erreicht.

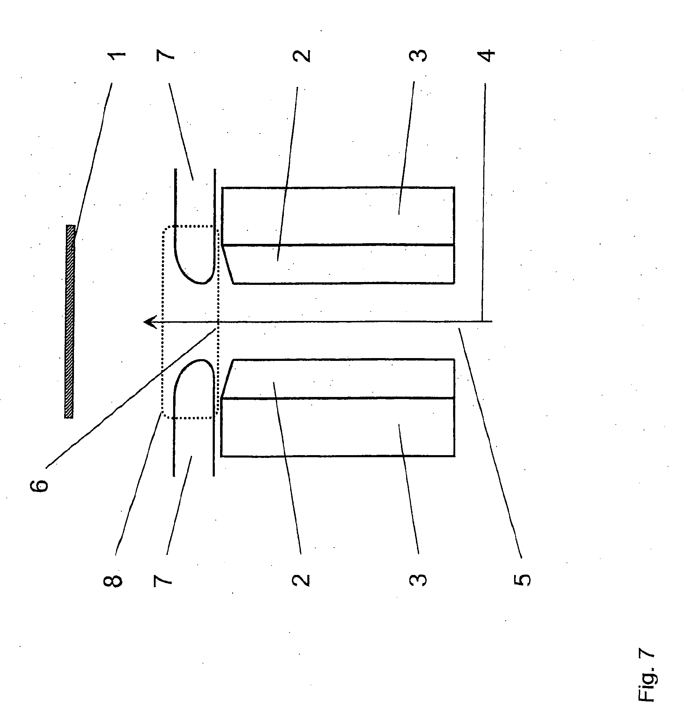

In Fig. 7 ist der freie Raum zwischen den Targets 2 und dem Quellengehäuse 7 im Mündungsbereich 6 im Vergleich zu Fig. 5 durch Abschrägen des Targets 2 deutlich vergrößert. Diese Ausführung ermöglicht einen besonders langen unterbrechungsfreien Betrieb der Gasflusssputterquelle, da sehr dicke Beläge auf dem Target 2 im Bereich der Ausströmöffnung 6 oder auf dem Gehäuse 7 im Mündungsbereich 6 aufwachsen können, ehe es zu Kurzschlüssen kommt.

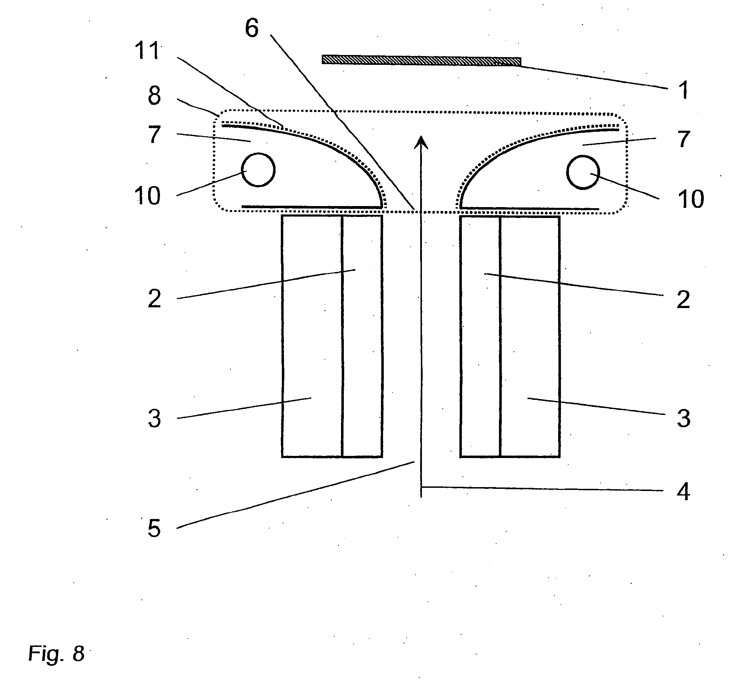

Fig. 8 zeigt eine Gasflusssputterquelle, die mit einer Vorrichtung 10, die entweder zum Kühlen oder zum Beheizen des Mündungsbereiches ausgestaltet ist, ausgestattet ist. Dadurch kann die Temperatur an der Oberfläche des Mündungsbereiches konstant niedrig gehalten werden, wodurch die Haftfestigkeit von Belägen erhöht wird. Alternativ kann anstelle der Kühlvorrichtung eine Heizvorrichtung mit Temperaturregelung vorgesehen werden, wodurch sich ebenfalls die Haftfestigkeit der Beläge erhöht. Außerdem ist in Fig. 8 die Gehäuse-Oberfläche im Mündungsbereich mit einem Metallnetz 11 belegt, welches durch seine große effektive Oberfläche sowie durch geometrische Verzahnung eine besonders hohe Haftfestigkeit der Beläge gewährleistet.

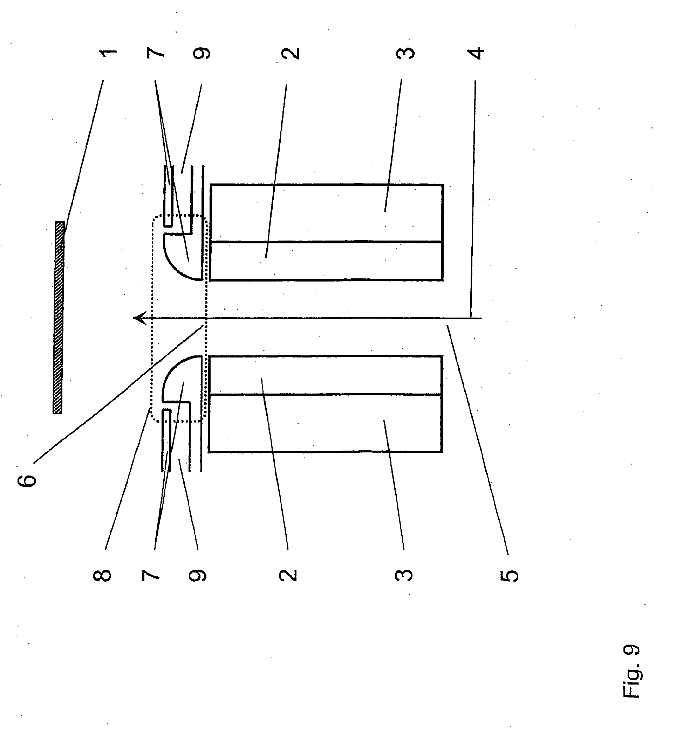

Fig. 9 zeigt eine Gasflusssputterquelle, die mit einer Einrichtung 9 zum Einspeisen eines Reaktivgases ausgestattet ist. Das Reaktivgas wird hierbei in sehr geringer Entfernung zum Plasma der Hohlkathodenglimmentladung zugeführt, wodurch es zu einer intensiven Anregung des Reaktivgases kommt. Gleichzeitig ist der Krümmungsradius der Oberfläche des Gehäuses auch in diesem Fall sehr groß (nämlich unendlich, da es sich um eine ebene Fläche handelt). Die den Austrittsspalt des Reaktivgases bildenden Kanten bleiben hierbei unberücksichtigt, da aufgrund der sehr geringen Schlitz-Weite und der Strömung des Reaktivgases hier keine Beläge entstehen.

### Bezugszeichenliste

1 - Substrat
2 - Target (Hohlkathode)
3 - Targetkühlung
4 - Inertgasstrom
5 - Einströmöffnung
6 - Ausströmöffnung
7 - Gehäuse
8 - Mündungsbereich
9 - Reaktivgaseinlass
10 - Kühl- oder Heizvorrichtung
11 - Metallnetz

## Patentansprüche

1. Gasflusssputterquelle mit einer Hohlkathode (2), die eine Eintritts- (5) und Austrittsöffnung (6) für Inertgas (4) aufweist,
**dadurch gekennzeichnet, dass** sich im Bereich der Austrittsöffnung (6) an die Hohlkathode (2) ein Gehäuse (7) anschließt, das eine Ausnehmung aufweist, deren Weite mindestens 80 % der Weite der Ausströmöffnung (6) beträgt, wobei zumindest die der Hohlkathode (2) abgewandte Seite des Gehäuses (7) eine gekrümmte Oberfläche aufweist.

2. Gasflusssputterquelle nach vorhergehendem Anspruch, **dadurch gekennzeichnet, dass** der Krümmungsradius mindestens 3 % der Weite der Ausströmöffnung beträgt, bevorzugt mindestens 10 %, besonders bevorzugt mindestens 20 %.

3. Gasflusssputterquelle nach einem der vorhergehenden Ansprüche, **dadurch gekennzeichnet, dass** der Krümmungsradius maximal das Dreifache der Weite der Ausströmöffnung beträgt.

4. Gasflusssputterquelle nach einem der vorhergehenden Ansprüche, **dadurch gekennzeichnet, dass** zumindest die Oberfläche der der Hohlkathode (2) abgewandten Seite, in Projektionsrichtung auf die der Hohlkathode (2) abgewandte Seite des Gehäuses (7), in einem ringförmigen oder zweifach streifenförmigen Bereich seitlich zur Ausnehmung hin gekrümmt ist, wobei der Bereich sich vom Rand der Ausströmöffnung (6) auf eine Länge von mindestens 10 %, bevorzugt mindestens 50 % der Weite der Ausströmöffnung erstreckt.

5. Gasflusssputterquelle nach einem der vorhergehenden Ansprüche, **dadurch gekennzeichnet, dass** die Krümmung kreisförmig, ellipsoid, hyperbolisch, zykloid, parabolisch oder sinusförmig verläuft.

6. Gasflusssputterquelle nach einem der vorhergehenden Ansprüche, **dadurch gekennzeichnet, dass** sowohl die der Hohlkathode (2) abgewandte Seite als auch die der Hohlkathode (2) zugewandte Seite des Gehäuses (7) eine gekrümmte Oberfläche aufweisen.

7. Gasflusssputterquelle nach einem der vorhergehenden Ansprüche, **dadurch gekennzeichnet, dass** die Weite der Ausnehmung des Gehäuses (7) mindestens 80 %, bevorzugt mindestens 90 %, weiter bevorzugt mindestens 100 %, besonders bevorzugt 100 % bis 150 %, insbesondere 100 % bis 120 % der Weite der Ausströmöffnung (6) beträgt.

8. Gasflusssputterquelle nach einem der vorhergehenden Ansprüche, **dadurch gekennzeichnet, dass** das Gehäuse (7) in Strömungsrichtung (4) des Inertgases beabstandet zur Hohlkathode (2) angeordnet ist, bevorzugt in einem Abstand zwischen 0,5 und 10 mm, besonders bevorzugt zwischen 2 und 4 mm.

9. Gasflusssputterquelle nach einem der vorhergehenden Ansprüche, **dadurch gekennzeichnet, dass** das Gehäuse (7) zumindest im Bereich der Ausnehmung aus einem Material mit einer Oberflächenenergie γ größer als 0,5 N/m, bevorzugt größer als 2 N/m ausgeführt ist, insbesondere aus Stahllegierungen und/oder Aluminium besteht.

10. Gasflusssputterquelle nach einem der vorhergehenden Ansprüche, **dadurch gekennzeichnet, dass** das Gehäuse (7) zumindest im Bereich der Ausnehmung aus einem Material mit einer Wärmeleitfähigkeit λ von mindestens 40 W/(m·K), bevorzugt 100 W/(m·K), besonders bevorzugt 250 W/(m·K) besteht.

11. Gasflusssputterquelle nach einem der vorhergehenden Ansprüche, **dadurch gekennzeichnet, dass** die Oberfläche des Gehäuses (7) zumindest im Bereich der Ausnehmung eine aufgeraute Oberfläche mit einem Rauwert Ra von mindestens 0,5 µm, bevorzugt mindestens 3 µm besitzt.

12. Gasflusssputterquelle nach einem der vorhergehenden Ansprüche, **dadurch gekennzeichnet, dass** die Oberfläche des Gehäuses (7) zumindest im Bereich der Ausnehmung mit einem Netz (11) überzogen ist, das bevorzugt aus dem gleichen Material gebildet ist, wie das Gehäuse (7) und/oder Vertiefungen, insbesondere Löcher, Rillen und/oder Furchen aufweist.

13. Gasflusssputterquelle nach einem der vorhergehenden Ansprüche, **dadurch gekennzeichnet, dass** das Gehäuse (7) mindestens eine Ausnehmung (9) zur Einleitung von Reaktivgas aufweist.

14. Gasflusssputterquelle nach einem der vorhergehenden Ansprüche, **dadurch gekennzeichnet, dass** das Gehäuse (7) mindestens eine Kühl- und/oder Heizvorrichtung (10) aufweist.

15. Gasflusssputterquelle nach einem der vorhergehenden Ansprüche, **dadurch gekennzeichnet, dass** die Austrittsöffnung (6) der Hohlkathode (2) eine konische Absenkung aufweist.
